# EUROPEAN PATENT SPECIFICATION

(11) **EP 3 113 238 B1**
(45) Date of publication and mention of the grant of the patent: **19.06.2019**
(21) Application number: 16163581.8
(22) Date of filing: 01.04.2016
(51) Int. Cl.: H01L 35/30, B64D 41/00

(54) **POWERING AIRCRAFT SENSORS USING THERMAL CAPACITORS**
STROMVERSORGUNG VON FLUGZEUGSENSOREN MITHILFE THERMISCHER KONDENSATOREN
CAPTEURS D'ALIMENTATION D'AÉRONEF UTILISANT DES CONDENSATEURS THERMIQUES

(30) Priority: 30.06.2015 US 201514755122
(43) Date of publication of application: 04.01.2017
(73) Proprietor: The Boeing Company, Chicago, IL 60606-2016 (US)
(72) Inventor: HILLER, Nathan D., CHICAGO, IL Illinois 60606-2016 (US)
(74) Representative: Cabinet Plasseraud

(56) References cited:
- EP-A1- 2 662 285
- EP-A2- 2 482 352
- D. SAMSON ET AL: "Wireless sensor node powered by aircraft specific thermoelectric energy harvesting", SENSORS AND ACTUATORS A: PHYSICAL, vol. 172, no. 1, 1 December 2011 (2011-12-01), pages 240-244, XP055071278, ISSN: 0924-4247, DOI: 10.1016/j.sna.2010.12.020

## Description

### BACKGROUND

Examples of the disclosure relate generally to the field of electrical power generation for aircraft and more particularly to a system for powering aircraft auxiliary system such as sensors employing a thermoelectric generator for generating electricity based on a temperature differential using a thermal capacitor already existing in the vehicle and having a primary function on the vehicle other than as a thermal capacitor.

Modern aircraft employ electrical power for numerous on board systems. Conventional generation of electricity for such usage is accomplished with engine or auxiliary power unit (APU) driven generators located in the aircraft. Power from the generators is then routed through the aircraft for use with standard electrical cabling in numerous wire harnesses. Issues of weight for the extensive wiring systems as well as the potential for undesirable electrical discharge within the circuit system have prompted examination of alternative power routing techniques.

Thermoelectric generators have been used in aircraft and other vehicles to provide electrical power generation alternatives. However, these uses are typically associated with heat generated by burning fuel. In these applications, location of the heat sources limits the location of the thermoelectric generator and therefore the wiring distance issues may be present even with the alternative power source. Additionally, power is only generated when fuel is being burned.

EP 2 482 352 A2 describes an electric generator that includes a thermoelectric generator which is in thermal contact with the structure of the aircraft; an insulated housing containing a thermal mass. The insulated housing is positioned in thermal contact with the thermoelectric generator and during the temperature cycles encountered by the structure of the aircraft, electrical energy is created by the thermoelectric generator. The generator does not require a heat sink, only a thermal source that varies in temperature over time. The system uses a small and insulated thermal mass (preferably less than 50 grams) preferably filled with a water and glycol mixture. EP 2 662 285 A1 describes an electric generator which employs a thermoelectric generator able to produce electrical power using potential energy that exists between the warm cabin air (requiring heat generated by burning fuel) of the aircraft and the external cold air at cruising altitudes. The generator is placed between an aircraft inner skin and an aircraft outer skin of the heated cabin with the warm cabin air. D. SAMSON ET AL: "Wireless sensor node powered by aircraft specific thermoelectric energy harvesting", SENSORS AND ACTUATORS A: PHYSICAL, vol. 172, no. 1, 1 December 2011 (2011-12-01), pages 240-244, XP055071278, ISSN: 0924-4247, DOI: 10.1016/j.sna.2010.12.020 describes an energy harvesting autonomous power source that utilizes aircraft specific outside temperature changes that occur as the aircraft envelope experiences huge and fast temperature changes.

Aircraft and other vehicles often have systems which may provide thermal mass reacting to a temperature differential to act as thermal capacitors. Since such systems are primarily for purpose other than the thermal capacitance capability, that capability is wasted and in some cases not enhanced.

It is therefore desirable to provide an electrical generation system which employs existing thermal capacitors in a vehicle to provide power for auxiliary systems.

### SUMMARY

Examples disclosed herein provide a power generation system comprising: a principal system incorporated in an aircraft, being one of a water tank, a fuel tank and a cargo container having a primary function other than as a thermal capacitor, said principal system having an associated mass providing a thermal capacitor; a thermoelectric generator placed for operational engagement between the thermal capacitor and an external environment, said thermoelectric generator configured to utilize a temperature differential between the thermal capacitor and the external environment to generate an electric current; wherein said thermoelectric generator includes a first portion in thermal contact with said thermal capacitor and a second portion being in thermal contact with said external environment and that is at a different temperature than said thermal capacitor, a thermoelectric gradient being formed between said first portion and said second portion to generate said electric current; and, an auxiliary system associated with the principal system, said auxiliary system connected to operate using the electric current generated by said thermoelectric generator.

The examples provide for a method utilizing the power generation system for generation of electrical power from said thermal capacitor in said principal system for said auxiliary system such as a sensor associated with the principal system on said aircraft, said method comprising: mounting said thermoelectric generator to receive heat flow between said thermal capacitor in said principal system on said aircraft and a thermal sink; operating the aircraft at a cruising altitude providing low temperature air external to the aircraft; generating electrical power by the thermoelectric generator based on a temperature differential between the thermal capacitor and external air as a thermal sink; and operating said auxiliary system with the electrical power.

The features, functions, and advantages that have been discussed can be achieved independently in various examples of the present disclosure or may be combined in yet other examples further details of which can be seen with reference to the following description and drawings.

### BRIEF DESCRIPTION OF THE DRAWINGS

FIG. 1 is a schematic view of an aircraft as an example vehicle with multiple internal systems which may act as thermal capacitors in addition to their normal functions;
FIG. 2 is an example of a fuel tank thermal capacitor arrangement;
FIG. 3 is an example of a lavatory water storage tank thermal capacitor arrangement;
FIG. 4 is an example of a cargo container thermal capacitor arrangement;
FIG. 5 is a schematic representation of a thermoelectric generator operating with a thermal capacitor and a battery storage system for power leveling;
FIG. 6 is a schematic representation of a temperature monitoring application for a thermoelectric generator operating with a thermal capacitor; and,
FIG. 7 is a flow chart of operation of the thermoelectric generator for distributed generation of power for auxiliary system or sensor use.

### DETAILED DESCRIPTION

Examples disclosed herein provide electrical power for an auxiliary system in a vehicle using a thermoelectric generator deriving power from a thermal capacitor existing as a portion of a principal system having a primary function on the vehicle other than as a thermal capacitor. The thermoelectric generator is able to produce electrical power using the potential energy that exists between the temperature of the thermal capacitor and the external cold air or other external environment of the vehicle.

Using a commercial aircraft as an example vehicle in which the disclosed examples may be employed, such aircraft cruise at altitudes above the tropopause and extending well into the stratosphere. Air temperatures in this region of the atmosphere are nominally between -20° and -60° C. Operating altitudes even during climb and descent regularly provide significantly cooler air temperatures. Additionally, aircraft typically have large fuel tanks as a principal system having a primary function to supply fuel to the aircraft engines but which also provide a significant volume of fuel that has thermal inertia, i.e. it tends to remain at an initial temperature and only slowly conforms to a new environmental temperature. This thermal inertia allows the fuel or the fuel tank in which it is stored to act as a thermal capacitor. Additionally other on-board systems which have a primary function not associated with electrical power generation such as water systems for lavatories may also provide materials with sufficient volume and/or mass to provide high thermal inertia to act as thermal capacitors. In aircraft, cargo containers or cargo itself may also provide thermal inertia which may be employed as a thermal capacitor. Each of these principal systems has a primary function in the aircraft; fuel tanks supply fuel for the operation of the aircraft engines, water tanks supply water for galley or lavatory use and cargo containers are designated for the shipment of the cargo contained therein. However, the thermal capacitance offered by each system may provide secondary functionality.

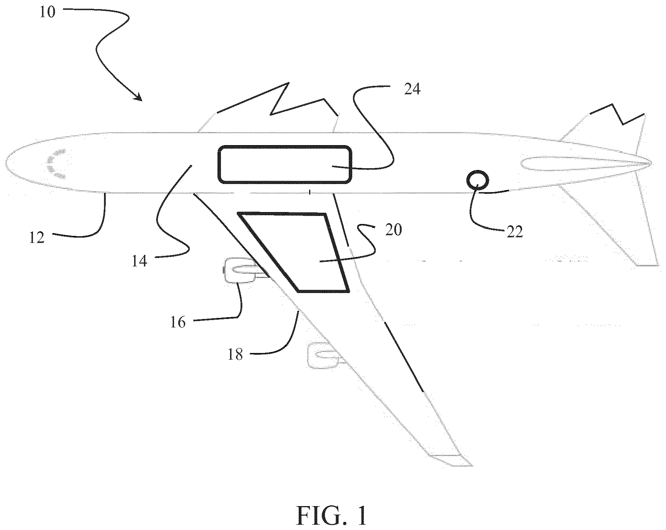

As shown in FIG. 1 for an exemplary aircraft system, the aircraft 10 has a fuselage 12 encompassing a cabin 14. Engines 16 (shown as mounted on the wings 18 for the present example but mounted on the empennage of the aircraft in alternative configurations) typically draw fuel from tanks 20 mounted internal to the wings 18. Such wing tanks may hold 3900kg or more of jet fuel which provides a significant thermal capacitance with respect to the exterior temperature of the wing 18 which may act as a thermal sink when the aircraft is in flight at altitude. The fuel tank as a thermal capacitor may be employed in conjunction with a thermoelectric generator to provide electrical power.

Additionally most aircraft include lavatories, galleys or other systems requiring water storage and one or more water tanks 22 are present, typically in the fuselage 14 of the aircraft. The water tanks 22 also provide a thermal capacitance which may be employed in conjunction with a thermoelectric generator for generation of electrical power.

Cargo being carried by the aircraft is typically situated in the fuselage 14 and in many cases cargo containers 24 provide significant mass which may be used as a thermal capacitor with external air or, for unheated/unpressurized cargo compartments, air within the compartment. Alternatively, the mass available may only act a thermal capacitance if certain temperature limits in the environment of the cargo container are exceeded which may then provide operation of a thermoelectric generator to power sensors or recorders for that temperature excursion.

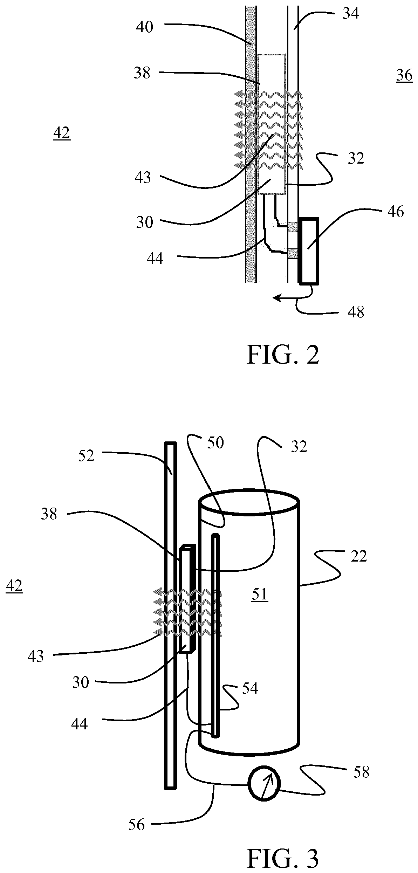

A first exemplary power generation system is shown in FIG. 2, wherein a thermoelectric generator 30 is located in thermal contact on a first surface 32 with a wall 34 of the fuel tank 20 as the principal system. Fuel in the tank 20 (generally designated 36) provides a mass to act as the thermal capacitor in addition to its primary functionality of providing fuel to the engines. A second surface 38 of the thermoelectric generator 30 is in thermal contact with a wing skin 40 on the surface of the wing 18. The temperature of the external air (generally designated 42) provides a temperature at the wing skin 40 as a reference element which provides a temperature differential between the first surface 32 and second surface 38 of the thermoelectric generator 30 creating a thermoelectric gradient for heat flow (generally designated by arrows 43) to provide electrical power to leads 44 which are connected to an auxiliary system such as a sensor 46. The sensor 46 may be, as examples, a fuel quantity gage, fuel temperature gage or explosive vapor detector to measure a desired physical phenomenon associated with the fuel tank, converting that phenomenon to an instrumentation signal and may provide redundancy to back up a primary system in the aircraft. Output from the sensor may be routed to displays or for other processing through output 48. While shown as a physical lead, output 48 may be either a wired or wireless communications channel. The operational engagement of the thermoelectric generator 30 between the fuel tank 20 as the thermal capacitor and wing skin 40 in contact with the external air having a different temperature than the thermal capacitor provides the thermoelectric gradient for desired generation of electric current.

A similar structural arrangement for use with a water tank 22 as the principal system is shown in FIG. 3. The thermoelectric generator 30 is positioned with first surface 32 in thermal contact with a wall 50 of the water tank 22 with water in the tank (generally designated 51) providing a mass acting as the thermal capacitor in addition to its primary functionality of providing water for use in the galley or lavatory. The second surface 38 of the thermoelectric generator 30 is in thermal contact with a skin 52 on the surface of the fuselage 14. The temperature of the external air 42 again provides a temperature differential between the first surface 32 and second surface 38 of the thermoelectric generator 30 for heat flow 43 to provide electrical power to leads 44 which are connected to a sensor 54 as the auxiliary system. The sensor 54 may be, as an example, a capacitive level or quantity gauge for the water tank. Output from the sensor 54 may be routed through output lead 56 to a displays 58 located adjacent the water tank location or remotely.

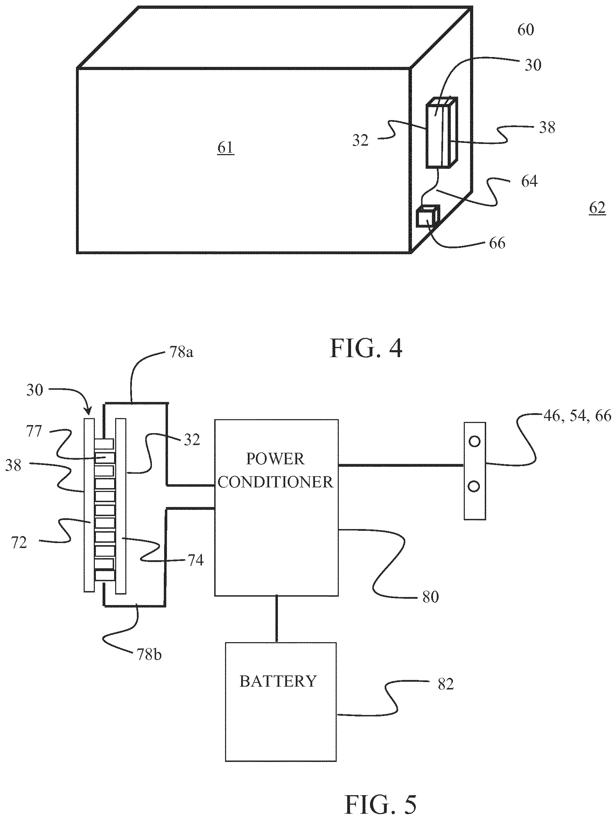

FIG. 4 shows an example employing a cargo container 24. The thermoelectric generator 30 is positioned with first surface 32 in thermal contact with a wall 60 of the cargo container 24 with mass of cargo and dead air volume in the container (generally designated 61) providing a mass acting as the thermal capacitor in addition to its primary functionality of providing shipment of the cargo. The second surface 38 of the thermoelectric generator 30 is in thermal contact the environment (generally designated 62) surrounding the container 24. The temperature of the environment 62 may provide a temperature differential between the first surface 32 and second surface 38 of the thermoelectric generator 30 for heat flow 43 to provide electrical power to leads 64 which are connected to an auxiliary system 66. The auxiliary system 66 may be, as examples, a temperature sensor or a GPS location sensor/transmitter.

While principally described herein as operating between a higher temperature of the thermal capacitor and a lower external or environmental temperature, the examples disclosed may also operate where the thermal capacitance of the principal system is at a lower temperature and the external environment is at a higher temperature. In such examples, the auxiliary system may be a sensor as described or may be such implementations as a fan to circulate cooling air in a shipping container where the external temperature exceeds a desired value. The auxiliary system may be connected to negatively compensate (i.e. provide negative feedback) for the change in temperature (e.g. fan or cooling device, or a heating device directed at or applied to a particularly sensitive part of the cargo or vehicle to avoid damage or equalize the temperature of an item. This functionality would additionally speed up or delay the thermal inertia in the thermal capacitor. Additionally, the thermoelectric generator may operate when the temperature of the thermal capacitor is either higher or lower and the reference element and/or the environmental sink. While described as an aircraft in principal examples herein, the vehicle may be a spacecraft, an aircraft, a helicopter, a lighter-than-air craft, an underwater vehicle, and a missile as alternative examples.

The operating elements of an exemplary thermoelectric generator 30 are shown in FIG. 5. A cold plate 72 and a hot plate 74 are fabricated from alumina ceramic or similar material which may be metalized. The hot plate 72 and cold plate 74 are mounted on opposite sides of a thermoelectric stack 76 which may employ Seebeck effect, the Peltier effect, or the Thomson effect for generation of electrical current. In an example, the stack is fabricated from bismuth telluride (Bi2Te3) semiconductor p-n junctions that are electrically connected in series or parallel or combination of the two. Electrical power generated by the stack 76 is then provided through leads 78a and 78b. As an example, a thermoelectric generator 30 may be created using one or an array of single stage operating elements 77 such as the model NL1010T produced by Marlow Industries Inc., Dallas, Texas. The hot and cold plates 72, 74 are thermally interfaced to mass of the thermal capacitor and a reference or sink such as the external environment or a skin or wall adjacent the external environment providing the temperature differential as previously described, either directly or on conductive extensions using thermal grease such as that produced by Marlow Industries with part no. # 860-3079-001 for optimal thermal conductivity. The cold plate 72 at its outer surface 38 conductively engages the outer skin of the wing or fuselage in the fuel tank and water tank examples or the environmental air for the cargo container example for heat transfer and the hot plate 74 interacts at its surface 32 with the thermal capacitor mass through direct conductive engagement of the wall 40, 52 or 60.

As also shown in FIG. 5, the thermoelectric generator 30 may provide generated power to a power conditioning module 80 which converts the generator output to desired current and voltage values (such as 12 volt or 28 volt DC or 110 volt AC) for the operating the associated auxiliary system such as the sensors 46, 54, 66. An electrical energy storage device such as battery 82 may be connected to the thermoelectric generator through the power conditioning system for power storage to allow powering of the associated sensors or other auxiliary system when thermal gradients may not be present for operation of the thermoelectric generator 30 or to supplement the power provided by the thermoelectric generator when the temperature differential is small. In alternative examples a capacitive storage system may be employed. With full thermal gradients, the power conditioning module 80 may charge the battery 82.

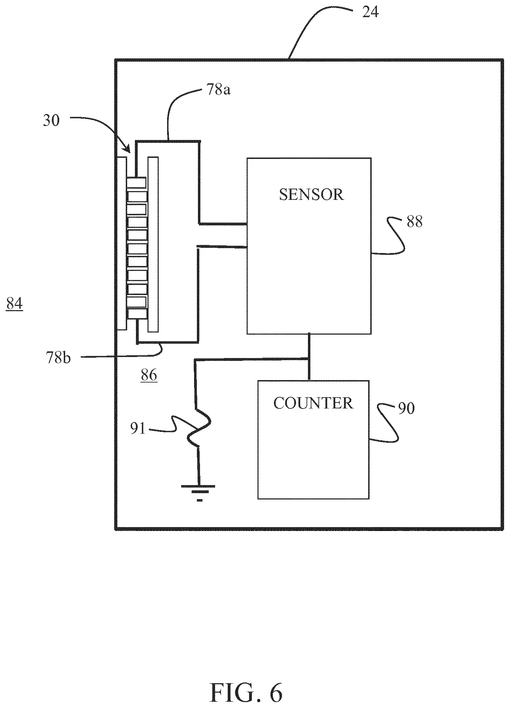

A particular application is shown in FIG. 6 wherein the thermoelectric generator 30 is attached to operate between an environment such as the outside 84 of a container 24 and the interior 86 of the container as the thermal capacitor. The thermoelectric generator would only be activated if a temperature differential of a predetermined amount exists between the outside environment 84 and the interior 86. A sensor 88 such as a temperature sensor constituting the auxiliary system would only receive current from the thermoelectric generator if the temperature differential was exceeded. The sensor would then activate to indicate the temperature. An actual temperature value may not be required from the temperature sensor but merely an indication that a threshold temperature had been exceeded. A counter 90 for counting the amount of time the temperature differential exceeds the threshold amount may be connected to the sensor 88 and powered by the thermoelectric generator 30 to provide a record for the product in the container 86 (e.g. a dairy product, wine bottle/case, or other product that may be degraded if exposed to an excessive temperature). The counter 90 may be a start-stop timer that can measure a cumulative amount of time in seconds, minutes, hours, or days, as needed. The counter 90 may be initialized based on a cycle of operation. For example if the thermoelectric generator 30, sensor 88 and/or counter 90 are a self-contained system attachable to the container 86, the counter may be initialized when the system is attached to the container. Alternatively, in the thermoelectric generator 30, sensor 88 and/or counter 90 are permanently affixed to the container 86 the counter 90 may be manually reset when the container is loaded and sealed.

The auxiliary system may also be or include a tripping element 91 such as a fuse or circuit breaker that disconnects the auxiliary system when a temperature differential is exceeded or merely acts as the indicator.

The thermoelectric generator 30, sensor 88 and counter 90 could be fabricated from low cost materials to provide a disposable single use system directly associated with or incorporated as a part of the container. Alternatively, the thermoelectric generator 30, sensor 88 and counter 90 could be a self-contained device which is removably attachable to the container 24.

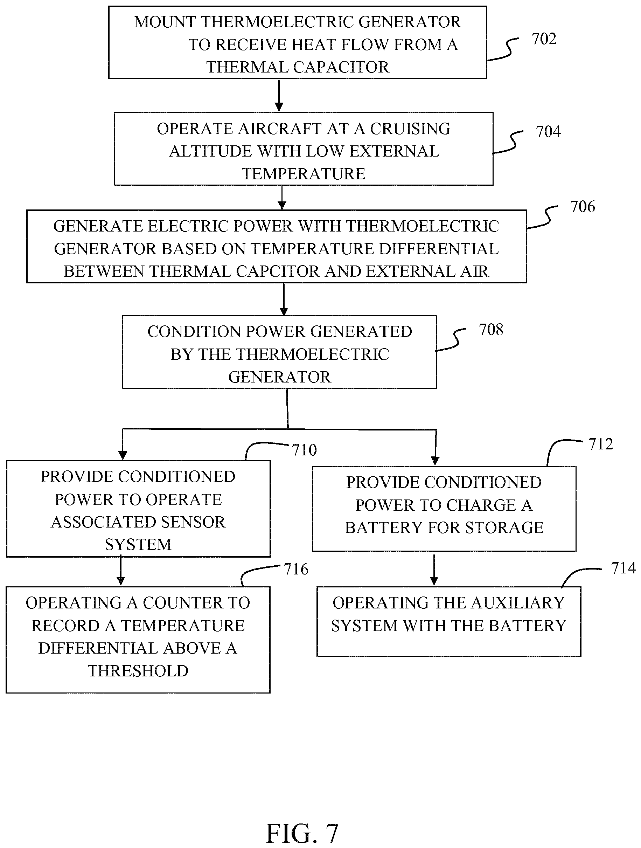

The examples disclosed provide a method for generation of electrical power from a thermal capacitor present in a principal system for an auxiliary system such as a sensor associated with the principal system on an aircraft as shown in FIG. 7. A thermoelectric generator is mounted to receive heat flow between the thermal capacitor and a thermal sink, step 702. The aircraft is then operated at a cruising altitude providing a low temperature external to the aircraft, step 704. Electrical power is then generated by the thermoelectric generator through the temperature differential between thermal capacitor and external air as the thermal sink, step 706. Generated electrical power from the thermoelectric generator can then be conditioned for proper voltage, step 708, and provided to operate an auxiliary system such as a sensor, step 710 or charge a power storage system such as a battery or capacitor for power storage to operate the sensor system, step 712. The battery may then be employed for operation of the auxiliary system if sufficient thermal gradient is not present for the thermoelectric generator to provide sufficient power, step 714. A counter may be operated when the thermoelectric generator is operating to record a temperature differential above a threshold, step 716

Having now described various examples of the disclosure in detail as required by the patent statutes, those skilled in the art will recognize modifications and substitutions to the specific examples disclosed herein. Such modifications are within the scope and intent of the present disclosure as defined in the following claims.

## Claims

1. A power generation system comprising:
a principal system (20, 22, 24, 51, 61) incorporated in an aircraft, being one of a water tank, a fuel tank and a cargo container having a primary function other than as a thermal capacitor, said principal system having an associated mass providing a thermal capacitor;
a thermoelectric generator (30) placed for operational engagement between the thermal capacitor and an external environment, said thermoelectric generator configured to utilize a temperature differential between the thermal capacitor and the external environment to generate an electric current; wherein said thermoelectric generator includes a first portion (32) in thermal contact with said thermal capacitor and a second portion (38) being in thermal contact with said external environment and that is at a different temperature than said thermal capacitor, a thermoelectric gradient being formed between said first portion and said second portion to generate said electric current; and,
an auxiliary system (46, 54, 66, 88, 91) associated with the principal system, said auxiliary system connected to operate using the electric current generated by said thermoelectric generator.

2. The power generation system as defined in claim 1, wherein
the first portion is a cold plate (72) in said thermal contact with an aircraft outer skin and the second portion is a hot plate (74) in said thermal contact with the thermal capacitor; and further comprising,
a thermoelectric stack (76) intermediate the cold plate and hot plate for electrical power generation.

3. The power generation system as defined in claim 2, wherein the thermoelectric stack operates using at least one of the Seebeck effect, the Peltier effect, or the Thomson effect for generation of electrical current.

4. The power generation system as defined in claim 3, wherein the thermoelectric stack comprises bismuth telluride "Bi2Te3" semiconductor p-n junctions.

5. The power generation system as defined in claim 1, wherein the auxiliary system is a sensor powered by the thermoelectric generator, the sensor converting a physical phenomenon into a signal, the sensor asserting the signal onto one of a wired or a wireless communications channel (48).

6. The power generation system as defined in claim 1, further comprising an electrical energy storage device (82) operatively connected to the thermoelectric generator, the storage device for storing electric power when the thermoelectric generator is providing power, the storage device for providing electric power when the thermoelectric generator is not providing power, and
wherein the storage device is one of a battery and a capacitive storage system.

7. The power generation system as defined in claim 1, further comprising a counter (90) for counting the amount of time the temperature differential exceeds a threshold amount, and
wherein the auxiliary system is a temperature sensor (88).

8. The power generation system as defined in claim 1 wherein the auxiliary system includes at least one of a fuse (91) or a circuit breaker and further comprises one of a cooling and a heating device, the one of the cooling and heating devices being connected to be powered by the thermoelectric generator to compensate for the change in temperature inside said cargo container.

9. A method utilizing the power generation system according to claim 1 for generation of electrical power from said thermal capacitor in said principal system (20, 22, 24, 51, 61) for said auxiliary system (46, 54, 66, 88, 91) such as a sensor associated with the principal system on said aircraft, said method comprising:
mounting (702) said thermoelectric generator (30) to receive heat flow between said thermal capacitor in said principal system (20, 22, 24, 51, 61) on said aircraft (10) and a thermal sink;
operating (704) the aircraft at a cruising altitude providing low temperature air external to the aircraft;
generating (706) electrical power by the thermoelectric generator based on a temperature differential between the thermal capacitor and external air as a thermal sink; and
operating (714) said auxiliary system with the electrical power.

10. The method as defined in claim 9, further comprising conditioning (708) power generated by the thermoelectric generator for use by the auxiliary system.

11. The method as defined in claim 9, further comprising charging (712) a power storage system with the generated electrical power.

12. The method as defined in claim 11, further comprising operating (714) the auxiliary system with the power storage system if sufficient thermal gradient is not present for the thermoelectric generator to provide sufficient power.

13. The method as defined in claim 9, wherein the step of operating the auxiliary system further comprises operating (716) a counter when the thermoelectric generator is operating to record a temperature differential above a threshold.

## Patentansprüche

1. Energieerzeugungssystem aufweisend:
ein in ein Flugzeug eingebautes Hauptsystem (20, 22, 24, 51, 61), das ein Wassertank, ein Kraftstofftank oder ein Frachtbehälter mit einer anderen Primärfunktion als der eines thermischen Kondensators ist, wobei das Hauptsystem eine zugeordnete Masse hat, die einen thermischen Kondensator und/oder Speicher bereitstellt;
einen thermoelektrischen Generator (30), der für eine betriebliche Kopplung zwischen dem thermischen Kondensator und einer Außenumgebung angeordnet ist, wobei der thermoelektrische Generator dafür konfiguriert ist, eine Temperaturdifferenz zwischen dem thermischen Kondensator und der Außenumgebung zu nutzen, um elektrischen Strom zu erzeugen; wobei der thermoelektrische Generator einen ersten Abschnitt (32), der in thermischem Kontakt mit dem thermischen Kondensator angeordnet ist, und einen zweiten Abschnitt (38) aufweist, der in thermischem Kontakt mit der Außenumgebung angeordnet ist und eine andere Temperatur hat als der thermische Kondensator, wobei zwischen dem ersten Abschnitt und dem zweiten Abschnitt ein thermoelektrischer Gradient ausgebildet wird, um den elektrischen Strom zu erzeugen; und
einem Zusatzsystem (46, 54, 66, 88, 91), das dem Hauptsystem zugeordnet ist, wobei das Zusatzsystem derart verbunden ist, dass es unter Verwendung des durch den thermoelektrischen Generator erzeugten elektrischen Stroms betreibbar ist.

2. Energieerzeugungssystem nach Anspruch 1, wobei
der erste Abschnitt eine kalte Platte (72) ist, die in thermischem Kontakt mit einer Flugzeugaußenhaut steht, und der zweite Abschnitt eine heiße Platte (74) ist, die in thermischem Kontakt mit dem thermischen Kondensator steht; und weiterhin aufweisend,
einen thermoelektrischen Stapel (76) zwischen der kalten Platte und der heißen Platte zum Erzeugen von elektrischem Strom.

3. Energieerzeugungssystem nach Anspruch 2, wobei der thermoelektrische Stapel unter Verwendung von mindestens dem Seebeck-Effekt, dem Peltier-Effekt, oder dem Thomson-Effekt zur Erzeugung von elektrischem Strom arbeitet.

4. Energieerzeugungssystem nach Anspruch 3, wobei der thermoelektrische Stapel Wismut-Tellurid- "Bi₂Te₃" Halbleiter-p-n-Übergänge aufweist.

5. Energieerzeugungssystem nach Anspruch 1, wobei das Zusatzsystem ein Sensor ist, der durch den thermoelektrischen Generator mit Energie versorgt wird, wobei der Sensor ein physikalisches Phänomen in ein Signal umwandelt, wobei der Sensor das Signal über einen drahtgebundenen oder einen drahtlosen Kommunikationskanal (48) bereitstellt.

6. Energieerzeugungssystem nach Anspruch 1, weiterhin aufweisend eine elektrische Energiespeichereinrichtung (82), die betrieblich mit dem thermoelektrischen Generator verbunden ist, wobei die Speichereinrichtung elektrische Energie speichert, wenn der thermoelektrische Generator Energie bereitstellt, und wobei die Speichereinrichtung elektrische Energie bereitstellt, wenn der thermoelektrische Generator keine Energie bereitstellt, und
wobei die Speichereinrichtung eine Batterie oder ein kapazitives Speichersystem ist.

7. Energieerzeugungssystem nach Anspruch 1, weiterhin aufweisend einen Zähler (90) zum Zählen der Zeitdauer, für die die Temperaturdifferenz einen Schwellenwert überschreitet, und
wobei das Zusatzsystem ein Temperatursensor (88) ist.

8. Energieerzeugungssystem nach Anspruch 1, wobei das Zusatzsystem eine Sicherung (91) oder einen Stromkreisunterbrecher aufweist und weiterhin eine Kühl- und eine Heizvorrichtung aufweist, wobei die eine Vorrichtung der Kühl- und der Heizvorrichtungen derart verbunden ist, dass sie durch den thermoelektrischen Generator mit Energie versorgt wird, um eine Temperaturänderung innerhalb des Frachtbehälters auszugleichen.

9. Verfahren unter Verwendung des Energieerzeugungssystems nach Anspruch 1 zur Erzeugung von elektrischer Energie von dem thermischen Kondensator im Hauptsystem (20, 22, 24, 51, 61) für das Zusatzsystem (46, 54, 66, 88, 91), wie beispielsweise einen Sensor, der dem Hauptsystem auf dem Flugzeug zugeordnet ist, wobei das Verfahren aufweist:
Montieren (702) des thermoelektrischen Generators (30) zum Empfangen eines Wärmeflusses zwischen dem thermischen Kondensator im Hauptsystem (20, 22, 24, 51, 61) auf dem Flugzeug (10) und einer Wärmesenke;
Betreiben (704) des Flugzeugs in einer Reiseflughöhe, die eine niedrige Lufttemperatur außerhalb des Flugzeugs bereitstellt;
Erzeugen (706) von elektrischer Energie durch den thermoelektrischen Generator basierend auf einer Temperaturdifferenz zwischen dem thermischen Kondensator und Außenluft als eine Wärmesenke; und
Betreiben (714) des Zusatzsystems durch die elektrische Energie.

10. Verfahren nach Anspruch 9, weiterhin aufweisend Konditionieren (708) von Energie, die durch den thermoelektrischen Generator zur Verwendung durch das Zusatzsystem erzeugt wird.

11. Verfahren nach Anspruch 9, weiterhin aufweisend Laden (712) eines Energiespeichersystems mit der erzeugten elektrischen Energie.

12. Verfahren nach Anspruch 11, weiterhin aufweisend Betreiben (714) des Zusatzsystems durch das Energiespeichersystem, wenn kein ausreichender thermischer Gradient für den thermoelektrischen Generator zum Bereitstellen von ausreichend Energie vorhanden ist.

13. Verfahren nach Anspruch 9, wobei der Schritt zum Betreiben des Zusatzsystems weiterhin das Betreiben (716) eines Zählers aufweist, wenn der thermoelektrische Generator betrieben wird, um eine Temperaturdifferenz oberhalb eines Schwellenwertes aufzuzeichnen.

## Revendications

1. Système de génération d'électricité, comprenant :
un système principal (20, 22, 24, 51, 61) incorporé dans un aéronef, étant l'un d'un réservoir d'eau, d'un réservoir de carburant et d'un conteneur de marchandises ayant une fonction primaire autre qu'en tant que capacité thermique, ledit système principal ayant une masse associée fournissant une capacité thermique ;
un générateur thermoélectrique (30) placé pour l'entrée en prise fonctionnelle entre la capacité thermique et un environnement externe, ledit générateur thermoélectrique étant configuré pour utiliser un différentiel de température entre la capacité thermique et l'environnement externe pour générer un courant électrique ; dans lequel ledit générateur thermoélectrique inclut une première portion (32) en contact thermique avec ladite capacité thermique et une seconde portion (38) en contact thermique avec ledit environnement externe et qui est à une température différente de celle de ladite capacité thermique, un gradient thermoélectrique étant formé entre ladite première portion et ladite seconde portion pour générer ledit courant électrique ; et,
un système auxiliaire (46, 54, 66, 88, 91) associé au système principal, ledit système auxiliaire étant connecté pour fonctionner en utilisant le courant électrique généré par ledit générateur thermoélectrique.

2. Système de génération d'électricité selon la revendication 1, dans lequel
la première portion est une plaque froide (72) dans ledit contact thermique avec un revêtement extérieur d'aéronef et la seconde portion est une plaque chaude (74) dans ledit contact thermique avec la capacité thermique, et comprenant en outre,
un empilement thermoélectrique (76) entre les plaque froide et plaque chaude pour la génération de puissance électrique.

3. Système de génération d'électricité selon la revendication 2, dans lequel l'empilement thermoélectrique fonctionne en utilisant au moins l'un de l'effet Seebeck, de l'effet Peltier, ou de l'effet Thomson pour la génération de courant électrique.

4. Système de génération d'électricité selon la revendication 3, dans lequel l'empilement thermoélectrique comprend des jonctions p-n à semi-conducteur tellurure de bismuth « Bi2Te3 ».

5. Système de génération d'électricité selon la revendication 1, dans lequel le système auxiliaire est un capteur alimenté par le générateur thermoélectrique, le capteur convertissant un phénomène physique en un signal, le capteur imposant le signal sur l'un d'un canal de communication câblé ou sans fil (48).

6. Système de génération d'électricité selon la revendication 1, comprenant en outre un dispositif de stockage d'énergie électrique (82) fonctionnellement connecté au générateur thermoélectrique, le dispositif de stockage étant destiné à stocker une puissance électrique lorsque le générateur thermoélectrique fournit de l'électricité, le dispositif de stockage étant destiné à fournir une puissance électrique lorsque le générateur thermoélectrique ne fournit pas d'électricité, et
dans lequel le dispositif de stockage est l'un d'une batterie et d'un système de stockage capacitif.

7. Système de génération d'électricité selon la revendication 1, comprenant en outre un compteur (90) pour compter le nombre de fois que le différentiel de température dépasse une quantité seuil, et
dans lequel le système auxiliaire est un capteur de température (88).

8. Système de génération d'électricité selon la revendication 1 dans lequel le système auxiliaire inclut au moins l'un d'un fusible (91) ou d'un disjoncteur et comprend en outre l'un d'un dispositif de refroidissement et de chauffage, l'un d'un dispositif de refroidissement et de chauffage étant connecté pour être alimenté par le générateur thermoélectrique pour compenser le changement de température à l'intérieur dudit conteneur de marchandises.

9. Procédé utilisant le système de génération d'électricité selon la revendication 1 pour la génération de puissance électrique à partir de ladite capacité thermique dans ledit système principal (20, 22, 24, 51, 61) pour ledit système auxiliaire (46, 54, 66, 88, 91) tel qu'un capteur associé au système principal sur ledit aéronef, ledit procédé comprenant :
le montage (702) dudit générateur thermoélectrique (30) pour recevoir un flux de chaleur entre ladite capacité thermique dans ledit système principal (20, 22, 24, 51, 61) sur ledit aéronef (10) et un dissipateur thermique ;
le fonctionnement (704) de l'aéronef à une altitude de croisière, fournissant de l'air à basse température externe à l'aéronef ;
la génération (706) de puissance électrique par le générateur thermoélectrique sur la base d'un différentiel de température entre la capacité thermique et de l'air externe en tant que dissipateur thermique ; et
le fonctionnement (714) dudit système auxiliaire avec la puissance électrique.

10. Procédé selon la revendication 9, comprenant en outre le conditionnement (708) de l'électricité générée par le générateur thermoélectrique pour l'utilisation par le système auxiliaire.

11. Procédé selon la revendication 9, comprenant en outre la charge (712) d'un système de stockage d'énergie électrique avec la puissance électrique générée.

12. Procédé selon la revendication 11, comprenant en outre le fonctionnement (714) du système auxiliaire avec le système stockage d'électricité si un gradient thermique suffisant n'est pas présent pour le générateur thermoélectrique pour fournir suffisamment d'électricité.

13. Procédé selon la revendication 9, dans lequel l'étape du fonctionnement du système auxiliaire comprend en outre le fonctionnement (716) d'un compte lorsque le générateur thermoélectrique fonctionne pour enregistrer un différentiel de température supérieur à un seuil.
